# EUROPEAN PATENT APPLICATION

(11) **EP 3 275 573 A1**
(43) Date of publication of application: **31.01.2018**
(21) Application number: 16768683.1
(22) Date of filing: 18.03.2016
(51) Int. Cl.: B22F 1/00, B22F 3/14, C22C 1/04, C22C 27/02, C22C 27/04, C22C 30/00, C22C 14/00, C22C 16/00, C22C 27/06, C22C 28/00

(54) **POLYCRYSTALLINE TUNGSTEN, TUNGSTEN ALLOY SINTERED COMPACT, AND METHOD FOR MANUFACTURING SAME**

(30) Priority: 23.03.2015 JP 2015060039; 15.03.2016 JP 2016051244
(71) Applicant: Mitsubishi Materials Corporation, Chiyoda-ku Tokyo 100-8117 (JP)
(72) Inventor: AKHMADI EKO Wardoyo, Naka-shi Ibaraki 311-0102 (JP); MATSUO Toshihiko, Naka-shi Ibaraki 311-0102 (JP); SAKURAZAWA Chihiro, Naka-shi Ibaraki 311-0102 (JP); MATSUMOTO Shotaro, Joso-shi Ibaraki 300-2795 (JP)
(74) Representative: Gille Hrabal
(86) International application number: PCT/JP2016/058713
(87) International publication number: WO 2016/152780

(57) **Abstract**

A polycrystalline tungsten compact or a polycrystalline tungsten-bases alloy compact, having high density, made of a fine grain structure, and free of anisotropy, is produced by: preparing a raw material powder made of W particles, a raw material powder in which W powder and an alloy component particle powder of one or more selected from Ti, Zr, Hf, V, Nb, Ta, Cr, Mo and Mn are blended, or a green compact thereof; inserting them in a pressure sintering apparatus; and sintering them in a state where a pressing of 2.55 GPa or more and 13 GPa or less is loaded on the either of the raw material powders or the green compacts in a temperature range of 1200°C or more and a melting point or less. A relative density of the compact is 99% or more, a porosity of the compact measured in an arbitrary cross section of the compact is 0.2 area% or less, an average crystal grain size is 50 µm or less, and an average aspect ratio of crystal grains is 1 to 2.5.

## Description

### Technical Field

The present invention relates to a polycrystalline tungsten compact, a tungsten alloy compact, and method of producing the same.

Priority is claimed on Japanese Patent Application No. 2015-60039, filed March 23, 2015, and Japanese Patent Application No. 2016-051244, filed March 15, 2016,the contents of which are incorporated herein by reference.

### Background Art

Polycrystalline tungsten and polycrystalline tungsten alloys are used in many fields. For example, they are used for non-consumable electrodes for welding, target materials, X-ray shielding materials, corrosion resistant materials, and the like. Generally, high strength, hardness and high specific gravity are required for these polycrystalline tungsten and polycrystalline tungsten alloy.

For example, conventionally known uses and producing methods of these polycrystalline tungsten and polycrystalline tungsten alloy include ones described in Patent Literatures 1 to 4 (PTLs 1 to 4) below.

In PTL 1, an electrode for fusing welding, which is heated and pressed repeatedly, is described. In order to suppress: wear due to separation of grains; and fracture, on the tip part, and to stably improve the durability, as a core material for the electrode of the dual structure electrode in which the electrode core material of W, Mo or an alloy based on W or Mo is attached to the tip part of the electrode main body made of Cu or Cu alloy, usage of W, Mo or an alloy based on W or Mo as an electrode material for fusing welding is proposed. It is sintered, subjected to swaging process and thermal annealing process; and has an axially extending fibrous structure so that the average cross-sectional particle diameter and the aspect ratio are set to 50 µm or more and 1.5 or more, respectively.

In order to improve: purification effect of molybdenum, tungsten, the highly pure refractory metal with molybdenum or tungsten as a major component, or an alloy thereof; and greatly improve functionalities (such as superconducting property, corrosion resistance, and high temperature heat resistance) and workability (such as forgeability, rolling property, and machinability) of the material, PTL 2 describes improvement of removal effectiveness of impurities. In the method described in PTL 2, each of impurities, which is included in the dissolved materials in the form of low-order compound or non-stoichiometric compound with gas components of impurities (products obtained by phase transformation between: additive elements or impurity metals; and the impurity gas components, or stoichiometric compounds of each of metals, in a high-pressure and high-temperature condition), is removed at once by volatilization by: press-molding molybdenum, tungsten, the highly pure refractory metal with molybdenum or tungsten as a major component, or an alloy thereof, and a powder of transition metal elements of vanadium, chromium, manganese, iron, cobalt, and nickel or one or more additive elements selected from the rare earth elements or small lumps of raw material in advance; and melting it with electron beam after sintering the green compact further at high temperature of 1000°C or more and in high pressure of 100MPa or more.

In PTL 3, a resistance welding electrode is proposed. In the resistance welding electrode described in PTL 3, the material of the resistance welding electrode is made of a sintered alloy of any one of tungsten and molybdenum, the alloy being formed in a fibrous structure by rolling, in order to improve durability, impact resistance, and fracture resistance of the electrode. In addition, the end surface of the fibrous structure of the electrode material is configured to be the weld surface clamping the workpiece.

In addition, in PTL 4, a sputtering target material is described. In order to increase the density of the sputtering target material and lengthen the service life of the sputtering target used for manufacturing the flat panel display, it is proposed in PTL 4 that the density of the sputtering target material can be increased by producing a sintered compact having the relative density of 93% to 94.5% , and then, performing rolling or forging the sintered compact at the heating temperature of 1400°C to 1600°C in the combination of press-molding of a molybdenum-tungsten powder in a predetermined composition with a predetermined pressure and sintering at a predetermined sintering condition by using a molybdenum-tungsten alloy, which is made of 30 wt% to 70 wt% of tungsten and the molybdenum balance, for the relative density of the alloy to be 96% to 99.9%.

### Citation List

### Patent Literature

PTL 1: Japanese Unexamined Patent Application, First Publication No. 2008-73712 (A)
PTL 2: Japanese Unexamined Patent Application, First Publication No. H08-165528 (A)
PTL 3: Japanese Unexamined Patent Application, First Publication No. 2000-158178 (A)
PTL 4: Japanese Unexamined Patent Application, First Publication No. H09-3635 (A)
PTL 5: Japanese Unexamined Patent Application, First Publication No. 2003-226964 (A)

### Summary of Invention

### Technical Problem

As disclosed in PTLs 1 to 4, as the method of producing polycrystalline tungsten and polycrystalline tungsten alloy, the powder metallurgy method (refer PTLs 1, 3, 4, and 5) and the dissolution method (refer PTL 2) are well known

Since polycrystalline tungsten compacts and polycrystalline tungsten alloy compacts produced by the powder metallurgy method have low density (small specific gravity), a post-processing such as rolling, forging and the like is normally performed as a measure to increase the density (refer PTLs 3 and 4). However, when post-processing such as rolling, forging, and the like is performed, anisotropy is introduced in the crystal structure by the processing, so that anisotropy occurs in the properties (such as strength) of the sintered compact after processing.

On the other hand, when it is used in the state of low density for the tungsten target material of the sputtering target described in PTL 5, for example, there are major problems in quality of the target material such as increasing of particle defects in spurring deposition and the like

In the present context, "anisotropy" means the state where many crystal grains having a high aspect ratio are included in the crystal structures of the crystal grains constituting the sintered compact, and more specifically, it means that the average aspect ratio of the crystal grains exceeds 2.5.

When anisotropy occurs as the sintered compact characteristic of the polycrystalline tungsten compact and the polycrystalline tungsten alloy compact, it exhibits uneven behavior depending on the direction of the crystal grains locally (for example, wear uneven in a direction) in use of the part produced from these polycrystalline tungsten compact and the polycrystalline tungsten alloy compact.

The uneven behavior depending on the direction of the crystal grains causes deterioration of durability, reliability, or the like of the part produced from these polycrystalline tungsten compact and the polycrystalline tungsten alloy compact in the medium to long term. For example, when it is repeatedly used as an electrode material for resistance welding (refer PTL 3), cracks are likely to occur at the grain boundaries along the rolling direction. As a result, a relatively short service life is exhibited. Rolled tungsten has a fibrous structure, and cracking along the fibrous structure can be easily induced due to accumulation of residual stress.

On the other hand, when the polycrystalline tungsten and the polycrystalline tungsten alloy are produced by the dissolution method (refer PTL 2), the density is increased (high specific gravity). However, the crystal grains become larger than ones produced by the powder metallurgy method. In addition, anisotropy occurs since crystal growth rates differ due to the cooling temperature gradient in the solidification process in cooling. Accordingly, it is hard to produce polycrystalline tungsten and polycrystalline tungsten alloy with fine gains and uniform structure.

Depending on the purpose of use, there is an occasion where polycrystalline tungsten and polycrystalline tungsten alloy, which have the high density, is free of anisotropy (or has low anisotropy), and is made of fine structure, are needed. Thus, there is a demand for polycrystalline tungsten and polycrystalline tungsten alloy, which have the high density, is free of anisotropy (or has low anisotropy), and is made of fine structure.

### Solution to Problem

In order to obtain the polycrystalline tungsten and the polycrystalline tungsten alloy, which has the high density, is made of fine structure, and is free of anisotropy, the inventors of the present invention conducted extensive studies on varieties of production methods. As a result, they found that the polycrystalline tungsten compact and the polycrystalline tungsten alloy material, which have the high density, is free of anisotropy (or has low anisotropy), and is made of fine structure could be obtained by sintering a polycrystalline tungsten powder, a polycrystalline tungsten alloy powder, or a green compact of thereof in an extra high pressure of 2.5 GPa at a high temperature of 1200°C.

In addition, they found that the above-described polycrystalline tungsten compact and the polycrystalline tungsten alloy compact had: excellent strength and hardness; and uniform material properties.

The present invention is made based on the above-described findings, and has aspects shown below.
(1) A polycrystalline tungsten compact, having high density, made of a fine grain structure, and free of anisotropy, wherein
   a relative density of the compact is 99% or more,
   a porosity of the compact measured in an arbitrary cross section of the compact is 0.2 area% or less,
   an average crystal grain size is 50 µm or less, and
   an average aspect ratio of crystal grains is 1 to 2.5.
(2) The polycrystalline tungsten compact according to the above-described (1), wherein the porosity is 0.02 area% to 0.19 area %.
(3) The polycrystalline tungsten compact according to the above-described (1), wherein the porosity is 0.02 area% to 0.15 area %.
(4) The polycrystalline tungsten compact according to the above-described (1), wherein the average crystal grain size is 0.8 µm to 33.4 µm.
(5) The polycrystalline tungsten compact according to the above-described (1), wherein the average crystal grain size is 0.8 µm to 18.3 µm.
(6) The polycrystalline tungsten compact according to the above-described (1), wherein the average aspect ratio is 1.0 to 2.2.
(7) The polycrystalline tungsten compact according to the above-described (1), wherein the average aspect ratio is 1.0 to 1.4.
(8) A polycrystalline tungsten-based alloy compact, having high density, made of a fine grain structure, and free of anisotropy, wherein
   the polycrystalline tungsten-based alloy includes: tungsten at 25 mass% or more; and one or more of alloy components selected from Ti, Zr, Hf, V, Nb, Ta, Cr, Mo and Mn,
   a relative density of the compact is 99% or more,
   a porosity of the compact measured in an arbitrary cross section of the compact is 0.2 area% or less,
   an average crystal grain size is 50 µm or less, and
   an average aspect ratio of crystal grains is 1 to 2.5.
(9) The polycrystalline tungsten-based alloy compact according to the above-described (8), wherein the porosity is 0.02 area% to 0.19 area %.
(10) The polycrystalline tungsten-based alloy compact according to the above-described (8), wherein the porosity is 0.02 area% to 0.15 area %.
(11) The polycrystalline tungsten-based alloy compact according to the above-described (8), wherein the average crystal grain size is 0.8 µm to 33.4 µm.
(12) The polycrystalline tungsten-based alloy compact according to the above-described (8), wherein the average crystal grain size is 0.8 µm to 18.3 µm.
(13) The polycrystalline tungsten-based alloy compact according to the above-described (8), wherein the average aspect ratio is 1.0 to 2.2.
(14) The polycrystalline tungsten-based alloy compact according to the above-described (8), wherein the average aspect ratio is 1.0 to 1.4.
(15) A method of producing a polycrystalline tungsten compact or a polycrystalline tungsten-based alloy compact having high density, made of a fine grain structure, and free of anisotropy, the method including the steps of:
   preparing a raw material powder made of tungsten particles having an average grain size of 50 µm or less, or a raw material powder in which a tungsten particle powder having an average grain size of 50 µm or less and an alloy component particle powder of one or more selected from Ti, Zr, Hf, V, Nb, Ta, Cr, Mo and Mn having an average grain size of 50 µm or less are blended;
   inserting either of the raw material powders or a green compact of either of the raw material powders in a pressure sintering apparatus; and
   sintering the either of the raw material powders or the green compact in a state where a pressing of 2.55 GPa or more and 13 GPa or less is loaded on the either of the raw material powders or the green compact in a temperature range of 1200°C or more and a melting point or less.

### Advantageous Effects of Invention

In the W compact and the W alloy compact, which are aspect of the present invention, (hereinafter referred as "the W compact of the present invention" and "the W alloy compact of the present invention", respectively), the relative density of the sintered compact is 99% or more, the porosity of the sintered compact measured in an arbitrary cross section of the sintered compact is 0.2 area% or less, the average crystal grain size is 50 µm or less, and the average aspect ratio of crystal grains is 1 to 2.5. Therefore, they have high density, made of a fine grain structure, and free of anisotropy relative to the conventional W compact and W alloy compact. Accordingly, they can exhibit excellent properties in varieties of application fields, such as the target materials, the electrode materials, and the like, for a long term

### Brief Description of Drawings

FIG. 1 shows an example of a photographic image of the structure of the W compact of the present invention.
FIG. 2 shows an example of a photographic image of the structure of the W compact produced by the conventional method (combination of the powder metallurgy method and rolling).
FIG. 3 shows an example of a photographic image of the structure of the W compact produced by the conventional method (the dissolution method).
FIG. 4 shows an example of a photographic image of the structure of the W alloy (W: 50 mass%, Mo: 50 mass%) compact of the present invention.
FIG. 5 shows an example of a result in pore detection measured in the W alloy (W: 50 mass%, Mo: 50 mass%) compact of the present invention shown in FIG. 4 (Software used: Image J). The porosity was less than the detection limit.
FIG. 6 shows an example of a photographic image of the structure of the W alloy (W: 50 mass%, Mo: 50 mass%) compact produced by the conventional method (HIP method).
FIG. 7 shows an example of a result in pore detection measured in the W alloy (W: 50 mass%, Mo: 50 mass%) compact produced by the conventional method (HIP method) shown in FIG. 6 (Software used: Image J). The porosity was 0.659 area%.

### Description of Embodiments

"The relative density" in the present invention means the ratio of the density of the polycrystalline tungsten compact measured by the Archimedes method to the theoretical density of tungsten, and the density of the polycrystalline tungsten alloy compact to the theoretical density of the alloy determined by the contents of tungsten and the alloy component element.

In addition, any one of "the porosity (area%)", "the average crystal grain size (µm)", and "the average aspect ratio of crystal grains (long side of crystal grain/short side of crystal grain)" in the sintered compact means average values of measured values from structure observation on arbitrary cross section of the sintered compacts by using a scanning electron microscope (SEM) and an electron beam backscatter diffraction apparatus (EBSD).

In the observation of the structure with the above-mentioned EBSD, an observation field of 210 µm× 40 µm (length and width dimensions) of an arbitrary cross section of the sintered compact is taken as an observation field of view, and all the crystal grains contained in this observation field of view are taken as observation targets for obtaining the average value. In this case, crystal grains that exist on the boundaries of the observation visual field and only a part of these is included in the observation visual field are excluded from the observation targets.

"The average grain size" of the raw material powder means the grain size at the cumulative value of 50% in the grain size distribution obtained by the laser diffraction/scattering method (the Microtrack method) for the powder before sintering (cumulative median diameter: Median diameter, d50).

"The polycrystalline tungsten alloy compact" referred to in the present invention means a sintered compact made of a tungsten alloy containing 25 mass% or more of tungsten.

The present invention will be described in detail below.

Although the present invention relates to a polycrystalline tungsten compact and a polycrystalline tungsten alloy compact and a method for producing the same, in the following, the polycrystalline tungsten compact will be referred to as "W compact." The crystalline tungsten alloy compact is abbreviated as "W alloy compact", and tungsten is abbreviated as "W."

The W compact of the present invention is prepared by sintering W grain powder having the average particle diameter of 50 µm or less. When the purity of W particles is less than 99.9% by mass, the sinterability of the W compact tends to vary due to the impurity component contained in W. In addition, the structure, the material, and properties of the W compact tend to be inhomogeneous, so that the purity of the W particles is preferably 99.9% by mass or more.

Further, when performing sintering, W particles can be directly inserted in a pressure sintering apparatus and sintered, or alternatively, a green compact may be formed from the W particles in advance and inserted in the pressure sintering apparatus and sintered.

When the average grain size of the W grains of the raw material powder exceeds 50 µm, a fine grain structure having the average crystal grain size of the sintered compact of 50 µm or less cannot be obtained due to grain growth in sintering. Thus, the average grain size of W particles is set to 50 µm or less, and more preferable average grain size is 0.25 µm to 50 µm.

When the relative density of the W compact of the present invention is measured by the Archimedes method, the measured relative density is 99% or more, and high density is achieved.

When the relative density is less than 99%, the densification of the sintered compact is not sufficient. Therefore, the porosity cannot be reduced to 0.2 area% or less. Accordingly, the relative density of the W compact is set to 99% or more.

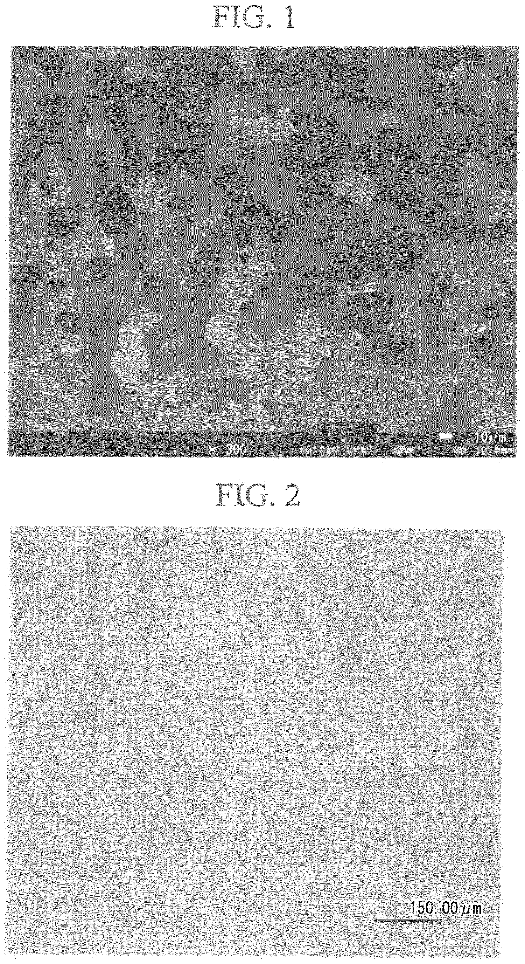

FIG. 1 shows an example of a photographic image of the structure of the W compact of the present invention. In the W compact shown in this photographic image of the structure, the presence of pores is not confirmed (porosity ≈ 0 area%) and it includes the isotropic crystal structure of fine grain structure satisfying the average crystal grain size of 50 µm or less and the average aspect ratio of the crystal grains of 1 to 2.5. The W compact of the present invention shown in FIG. 1 is sintered at 1700°C for 20 minutes in a state where the pressure of 6.1 GPa is applied. The relative density measured by the Archimedes method is 99.69% (specific gravity: 19.24), and has a high hardness of Vickers hardness HV of 460.

The Vickers hardness HV can be measured by the method specified in JIS standard Z2244.

The reason why the porosity of the sintered compact of the present invention is set to 0.2 area% or less is that when the porosity exceeds 0.2 area%, the W compact is not a highly-densified W compact with a large specific gravity. Moreover, when a W compact having a porosity exceeding 0.2 area% is used as a welding electrode, only the pore portion becomes in an insulated state, and it tends to be a breakdown starting point in high voltage welding particularly, for example. In addition, when a W compact having a porosity exceeding 0.2 area% is used as a target material, a portion of the pore leads to abnormal discharge or shows uneven wear.

Although not particularly essential, the preferred porosity ranges from greater than 0 area% to 0.2 area%. A more preferable range of the porosity is 0.02 area% to 0.19 area%. Even more preferred range of the porosity is 0.02 area% to 0.15 area%. Even more preferred range of the porosity is 0.02 area% to 0.12 area%.

The sintered compact of the present invention has the average crystal grain size of 50 µm or less because when the average grain size exceeds 50 µm, it becomes a coarse grain structure, and a fine grain structure excellent in strength and hardness cannot be obtained.

Although not particularly essential, the preferred average crystal grain size range is from 0.8 µm to 33.4 µm. A more preferable average crystal grain size range is 0.8 µm to 18.3 µm. Even more preferable range of the average crystal grain size is 2.6 µm to 14.0 µm.

The average aspect ratio of crystal grains (= long side of crystal gain/short side of crystal grain) in the sintered compact of the present invention is set to 1 to 2.5 because when the average aspect ratio is out of this range, anisotropy occurs in the crystal structure, and homogeneous materials and properties cannot be obtained. In this specification, "free of anisotropy" in the crystal structure means that the average aspect ratio of crystal gains in the target sintered compact is within the range of 1 to 2.5. Contrary to that, "having anisotropy" means that the average aspect ratio is out of the range of 1 to 2.5.

Although not particularly essential, the preferred average aspect ratio ranges from 1 to 2.2. More preferable average aspect ratio ranges from 1 to 1.4.

Since the W compact of the present invention has the porosity, the average crystal grain size, and the average aspect ratio of crystal grains measured in the above-described ranges in any arbitrary cross section of the sintered compact, not in a specific cross section, it is clear that the W compact has the structure free of anisotropy and with isotropy.

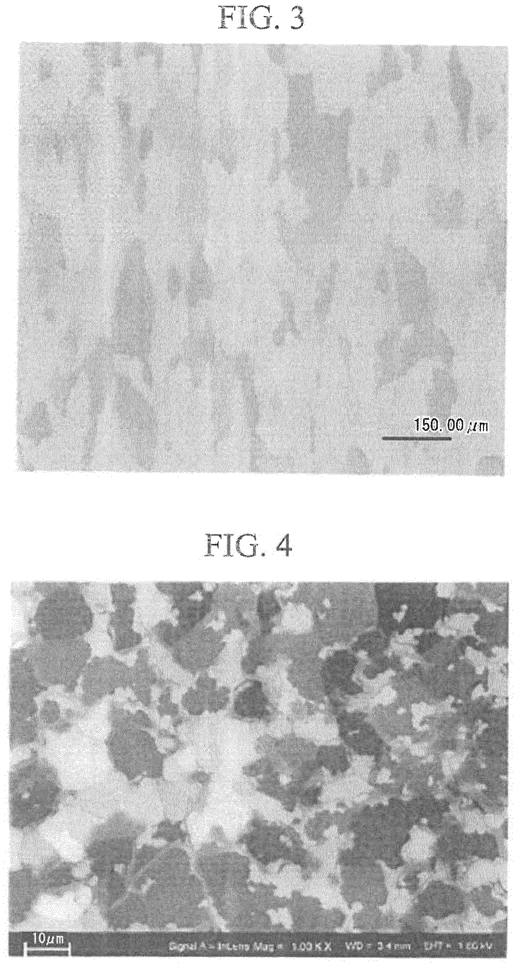

FIGS 2 and 3 show photographic images of the structure of the W compact prepared by the conventional method.

FIG 2 is an example of a photographic image of the structure along the rolling direction of the W compact (refer PTLs 3 and 4) produced by the combination of the powder metallurgy method and rolling.

It is possible to increase the density of the sintered compact to a certain extent by preparing W compact by the powder metallurgy method and then subjecting it to rolling and the like. In FIG. 2, the relative density: 99.48% (specific gravity: 19.2), and Vickers hardness HV: 500 are obtained.

However, on the other hand, since anisotropy occurs in the crystal structure of the sintered compact by being subjected to the processing (vertical stripe or fibrous crystal structure is observed in FIG. 2, the average aspect ratio in the plane along the rolling direction is 6. 5 or more), a sintered compact having the fine and uniform structure cannot be obtained. As a result, isotropic properties cannot be expected to this W compact.

FIG. 3 shows an example of a photographic image of the structure of the W compact produced by the dissolution method (refer PTL 2).

In the W compact obtained by the dissolution method shown in FIG. 3, sufficiently high densification is not obtained (relative density: 99.33% (specific gravity: 19.17)), and hardness (Vickers hardness HV: 440) is not enough. Furthermore, in the solidification process after melting, due to the cooling temperature gradient, the growth rate of the crystal varies and anisotropy occurs. Thus, a W compact of fine grain and uniform structure cannot be obtained.

The W compact of the present invention can be produced, for example, by the following method.

As described above, the W compact, which has the porosity, the average grain size and the average aspect ratio of the crystal grains defined by the scope of the present invention, having high density, made of a fine grain structure, and free of anisotropy is produced by inserting the W particle powder having the purity of 99.9 mass% or more and the average grain size of 0.25 µm to 50 µm after being sized in a pressure sintering apparatus and sintering it in a temperature range of 1200°C or more and a melting point or less (1200°C to 2000°C, for example) for 10 minutes or more in a state where a pressing of 2.55 GPa or more and 13 GPa or less is loaded on the powder.

When the sintering pressure is less than 2.55 GPa, the powder is not highly densified. On the other hand, loading a pressure exceeding 13 GPa is economically unfavorable in view of cost for developing the apparatus and actual operation. Thus, the sintering pressure is set to 2.55 GPa or more and 13 GPa or less.

In addition, when the sintering temperature is less than 1200°C, the solid phase reaction does not proceed. Contrary to that, when the sintering temperature exceeds the melting point, the same problems (for example, coarsening of the crystal grains and occurrence of anisotropy of the crystal structure in the solidification process) as in the dissolution method occurs, and the W compact having high density, a fine grain structure, and a uniform structure cannot be obtained. Therefore, the sintering temperature is set to a temperature range of 1200°C or more and a melting point or less, preferably 1200°C or more and 2000°C or less.

Alternatively, the W compact of the present invention can be obtained by preparing a green compact from the W particle powder in advance before sintering and sintering the green compact in the above-described pressure at the above-described sintering temperature for the above-described sintering time.

In the case where a fine W particle powder having a large specific surface is used as the raw material powder (for example, the average grain size of 0.25 µm to 4 µm), when the green compact is prepared from the raw material powder and the surfaces of the W particles are cleaned by heat treating in: vacuum atmosphere of 10⁻¹ Pa or less; or atmosphere in which contents of the heat treatment container are substituted by nitrogen gas, argon gas or the like, at the achieving temperature of 450°C to 1200°C for 30 minutes to 180 minutes prior to sintering, for example, the sintering reaction tends to proceed. Thus, high densification of the sintered compact in a short period of time is possible even in relatively low pressure condition and low temperature range.

Even if impurity elements such as oxygen and the like were present in the W particle powder at some extent, they could be removed/cleaned by the above-described heat treatment in vacuum or in the inert gas atmosphere; and the purity of the W particle powder can be increased to 99.9 mass% or more.

In terms of the average grain size of the W particle powder, it is preferable that is in the range of 0.25 µm to 50 µm as a whole. However, there is no need for the particle size distribution frequency to have a single peak (showing a unimodal particle size distribution frequency), and the W particle powder having multiple peaks in the particle size distribution frequency (showing a multimodal particle size distribution frequency) can be used. In this case, interspaces can be reduced by having particles with a small grain size get into the interspaces between grains with a large grain size. Thus, the sintering reaction proceeds further in relatively low pressure condition and low temperature range; and the sintered compact is highly densified further. Accordingly, the W compact having a fine grain structure free of anisotropy can be obtained.

In either case, a highly-densified W compact can be obtained by plastically deforming the W particles in high temperature and under high pressure and rearranging them by sintering in the above-described condition and giving a long enough sintering time.

The method to obtain the W compact is explained above. However, in the present invention, the W alloy compact having high density, made of a fine grain structure, and free of anisotropy can be obtained by using the raw material powder, in which the W particle powder and the alloy component particle powder of one or more selected from Ti, Zr, Hf, V, Nb, Ta, Cr, Mo and Mn as the alloy components are blended.

The W alloy compact, which includes each of one or more selected from Ti, Zr, Hf, V, Nb, Ta, Cr, Mo and Mn as an alloy component, is used as the resistance welding electrode material, target material, or the like. In either case, the W alloy compact having high density, made of a fine grain structure, and free of anisotropy is needed as in the W compact.

In the W alloy compact having a low W content, the sintered compact can be highly densified by a conventional method of producing a sintered compact such as HIP method and the like. However, for example, in the W alloy compact having the W content of 25 mass% or more, a W alloy compact having high density, made of a fine grain structure, and free of anisotropy cannot be obtained by the conventional methods.

However, according to the present invention, the W alloy compact having high density, made of a fine grain structure, and free of anisotropy can be obtained as in the above-described W compact even in the W alloy compact having the W content of 25 mass% or more and including one or more selected from Ti, Zr, Hf, V, Nb, Ta, Cr, Mo and Mn as alloy components.

The W alloy compact of the present invention can be produced by sintering in the same condition as the above-described W compact.

However, as the alloy component particle powder of one or more selected from Ti, Zr, Hf, V, Nb, Ta, Cr, Mo and Mn, which is a raw material powder, each of metal particle powders having the average grain size of 50 µm or less is used in view of miniaturizing the structure of the sintered compact.

The W alloy compact having high density, made of a fine grain structure, and free of anisotropy can be produced by inserting a raw material powder or a green compact prepared from the raw material powder in a pressure sintering apparatus and sintering. In the raw material powder, the W particle powder with the average grain size of 50 µm or less; and the alloy component particle powder of one or more selected from Ti, Zr, Hf, V, Nb, Ta, Cr, Mo and Mn with the average grain size of 50 µm or less, are blended so that the W content in the sintered compact becomes 25 mass% or more. Sintering is performed in the temperature range of 1200°C or more and the melting point or less in the state where a pressing of 2.55 GPa or more and 13 GPa or less is loaded on the either of the raw material powder or the green compact.

In the case where a powder having a large specific surface is used as the raw material powder (for example, the average grain size of 0.25 µm to 4 µm), when the green compact is prepared from the raw material powder and the surfaces of the particles are cleaned by heat treating in: vacuum atmosphere of 10⁻¹ Pa or less; or atmosphere in which contents of the heat treatment container are substituted by nitrogen gas, argon gas or the like, at the achieving temperature of 450°C to 1200°C for 30 minutes to 180 minutes prior to sintering, for example, high densification of the sintered compact in a short period of time is possible even in relatively low pressure condition and low temperature range. Even if impurity elements such as oxygen and the like were present in the W particle powder at some extent, they could be removed/cleaned by the above-described heat treatment in vacuum or in the inert gas atmosphere.

The reasons for setting the porosity, the average crystal grain size, and the average aspect ratio of the crystal grain of the W alloy compact of the present invention as described above are the same as in the W compact. Since the W alloy compact of the present invention has the porosity, the average crystal grain size, and the average aspect ratio of crystal grains measured in the above-described ranges in any arbitrary cross section of the sintered compact, not in a specific cross section, it is clear that the W alloy compact has the structure free of anisotropy and with isotropy in the same manner.

FIG. 4 shows an example of a photographic image of the structure of the W alloy compact of the present invention.

The W alloy compact shown in FIG 4 is a W-Mo alloy compact made of W: 50 mass%; and Mo: 50 mass%) and produced by sintering at 500°C for 20 minutes in a state where a pressing force of 5.8 GPa is loaded.

The relative density of the W-Mo alloy compact shown in FIG 4 measured by the Archimedes method is 99.32% (specific gravity: 13.27); and the W-Mo alloy compact is a high density W-Mo alloy compact. In addition, the W-Mo alloy compact has high hardness HV of 330 in the Vickers hardness.

The theoretical density of the W-Mo alloy compact made of 50 mass% of W and 50 mass% of Mo is 13.36 (theoretical density of W: 19.3; the theoretical density of Mo: 10.2).

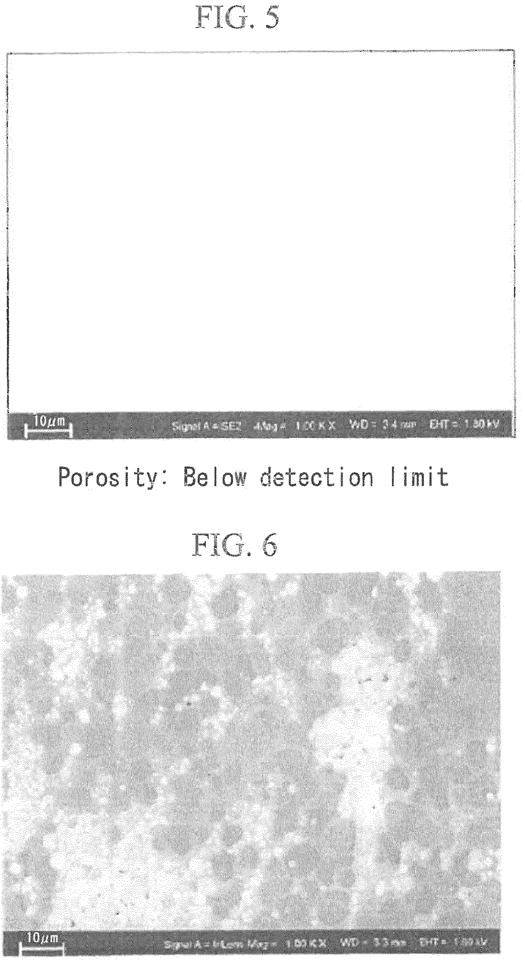

FIG. 5 shows a result in pore detection measured in the W-Mo alloy compact (hereinafter, referred as "the W-Mo alloy compact of the present invention") shown in FIG 4 (Software used: Image J).

According to FIG. 5, it is confirmed that the porosity of the W-Mo alloy compact of the present invention is less than the detection limit; and practically, there is no pore.

For comparison, a sintered compact of W-Mo alloy made of 50 mass% of W and 50 mass% of Mo having the same composition as the W-Mo alloy compact of the present invention is prepared by the conventional method (HIP method).

The producing conditions in the HIP method are a pressing force of 34.32 MPa at 1400°C for 3 hours.

FIG. 6 shows an example of a photographic image of the structure of the W-Mo alloy compact produced by the conventional method (HIP method).

When the relative density and the Vickers hardness HV of the W-Mo alloy compact produced by the conventional method (HIP method) are measured, the relative density is 96.33% (specific gravity: 12.87), and the Vickers harness HV is 255. Thus, both of the relative density and the hardness are inferior to the W-Mo alloy compact of the present invention.

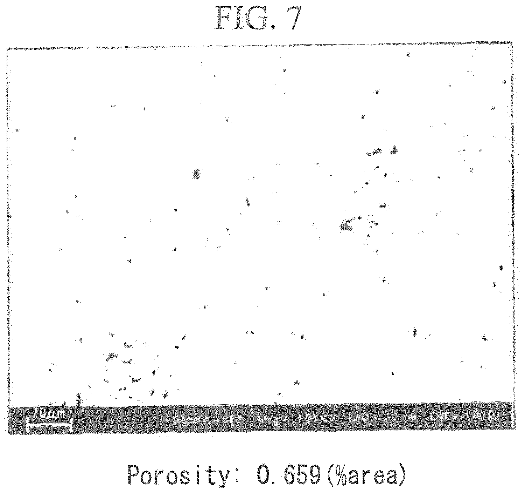

FIG. 7 shows an example of a result in pore detection measured in the W-Mo alloy compact produced by the conventional method (HIP method) shown in FIG 6 (Software used: Image J).

According to FIG. 7, the porosity is 0.659 area%, clearly demonstrating that high densification is not sufficient.

The present invention is explained in detail by Examples below.

### Example 1

As raw materials, W particle powders having the average grain size shown in Table 1 were prepared. Then, by pressure sintering in the sintering condition shown in Table 1, the W compacts 1 to 8 of Examples of the present invention were produced.

In the production of the W compacts 6 to 8 of Examples of the present invention, W particle powders having multiple peaks in the particle size distribution frequency (multimodal particle size distribution) shown in Table 1 were used as the raw material powder.

In the production of the W compacts 6 to 8 of Examples of the present invention, vacuum sintering was performed in vacuum atmosphere of 10⁻¹ Pa at the reaching temperature of 580 °C to 620°C for 30 to 40 minutes after producing the green compacts from the W particle powder prior to sintering.

Then, the relative densities (specific gravities) of these sintered compacts were measured by the Archimedes method. Then, one cross section X of the compact in an arbitrary direction was set in these sintered compacts. Then, the cross section Y and the cross section Z, both of which are perpendicular to the cross section X, were set. Then, the porosity, the average crystal grain size, and the average aspect ratio of the crystal grains in each of the cross sections X, Y, and Z were obtained by observation of the structures using a scanning electron microscope (SEM) and an electron beam backscatter diffraction device (EBSD). In addition, the Vickers hardness HV in the cross sections X, Y, and Z were measured.

The porosity was obtained by binarizing SEM images in the vertical and horizontal axes in magnification, in which about 15 to 30 of W particles were observed (for example, 3000 times when the W particle size was 2 µm to 4 µm; and 500 times when the W particle size was 10 µm to 20 µm), with the software, Image J; measuring portions corresponding and not corresponding to the pores; and averaging values from 3 different viewing fields.

The average crystal grain size and the average aspect ratio were calculated by averaging particle information obtained by EBSD in 3 different viewing fields in the same observation magnification described above.

The Vickers hardness HV was calculated by averaging values measured with the load of 1 kg in 5 different points.

These results are shown in Table 2.

An example of the structure of the W compact 5 of the present invention is shown in FIG. 1.

For comparison, W particle powders having the average grain size shown in Table 3 were prepared. Then, by sintering these powders in the sintering condition shown in Table 3 in the same manner, W compacts of Comparative Examples 1 to 5 having the relative density (specific gravity), the porosity, the average crystal grain size, the average aspect ratio of the crystal grains, and the Vickers hardness HV shown in Table 4 were produced.

On the W compacts of Comparative Examples 1 to 5, the relative density (specific gravity), the porosity, the average crystal grain size, the average aspect ratio, and the Vickers hardness HV shown in Table 4were obtained in the same manner as in Example 1.

These results are shown in Table 4.

In addition, as references, by using W particle powders having the average grain size shown in Table 3, W compacts 1 and 2 of Conventional Examples were produced by the conventional method.

On these W sintered materials 1 and 2 of Conventional Examples, the relative density (specific gravity), the porosity, the average crystal grain size, the average aspect ratio, and the Vickers hardness HV were obtained.

These results are shown in Table 4.

The W compact 1 of Conventional Example was obtained by performing rolling processing as described in PTLs 3 and 4. The W compact 2 of Conventional Example was produced by the dissolution method described in PTL 2.

FIG. 2 shows an example of the structure of the W compact 1 of Conventional Example along the surface in the rolling direction. FIG. 3 shows an example of the structure of the W compact 2 of Conventional Example.

The porosity, the average crystal grain size, the average aspect ratio and the Vickers hardness HV of the W compacts 1 to 5 of Comparative Examples and the W compacts 1 and 2 of Conventional Examples were obtained by the same methods as in the cases of the W compacts 1 to 8 of the present invention.

**[Table 1]**

| | No. | Average grain size of the W powder (µm) | Sintering pressure (GPa) | Sintering temperature (°C) | Sintering time (min) |
|---|---|---|---|---|---|
| Example of the present invention | 1 | 0.3 | 5.5 | 1500 | 30 |
| | 2 | 2.0 | 7.7 | 1500 | 20 |
| | 3 | 12.1 | 3.7 | 1400 | 60 |
| | 4 | 18.5 | 2.7 | 1600 | 180 |
| | 5 | 8.8 | 6.1 | 1700 | 20 |
| | 6 | 20vol%2.0 + 80vol%12.1 | 5.5 | 1600 | 30 |
| | 7 | 20vol%4.8 + 80vol%18.5 | 5.5 | 1600 | 30 |
| | 8 | 40vol%0.3 + 60vol%2.0 | 10 | 1600 | 20 |

| | | | | | |
|---|---|---|---|---|---|
| Note: There were multiple peaks in Examples 6-8 in the present invention. "Xvol%a+Yvol%b" means that it was a mixed powder containing X vol% of the W powder with the average grain size of a (µm) and Y vol% of the W powder with the average grain size of b (µm) | | | | | |

**[Table 2]**

| | No. | Relative density (%) | Porosity (area%) | | | Average crystal grain size (µm) | | | Average aspect ratio | | | Vickers hardness HV | | |
|---|---|---|---|---|---|---|---|---|---|---|---|---|---|---|
| | | | Cross section X | Cross section Y | Cross section Z | Cross section X | Cross section Y | Cross section Z | Cross section X | Cross section Y | Cross section Z | Cross section X | Cross section Y | Cross section Z |
| Example of the present invention | 1 | 99.5 | 0.15 | - | 0.18 | 1 | 0.8 | 1.2 | 1.2 | 1.9 | 2.2 | 451 | 449 | 432 |
| | 2 | 99.7 | - | 0.03 | - | 2.6 | 3.1 | 2.9 | 2.1 | 1.7 | 1.3 | 456 | 465 | 462 |
| | 3 | 99.3 | 0.08 | 0.16 | - | 17 | 16.6 | 15.2 | 1.8 | 2.2 | 1.4 | 452 | 461 | 453 |
| | 4 | 99.1 | 0.15 | 0.09 | 0.12 | 32.4 | 29.8 | 33.1 | 2.1 | 1.8 | 1.4 | 460 | 449 | 462 |
| | 5 | 99.7 | - | - | 0.03 | 9.6 | 10.1 | 9.8 | 1.2 | 1.4 | 1.1 | 450 | 470 | 460 |
| | 6 | 99.6 | - | 0.08 | 0.14 | 14.3 | 13.7 | 12.9 | 1.4 | 1.6 | 2.2 | 478 | 465 | 471 |
| | 7 | 99.6 | 0.05 | 0.02 | - | 28.1 | 26.7 | 30.2 | 1.3 | 2.1 | 1.9 | 468 | 472 | 480 |
| | 8 | 99.8 | - | - | - | 3.6 | 3.2 | 2.9 | 1.8 | 1.1 | 2.2 | 480 | 460 | 476 |

| | | | | | | | | | | | | | | |
|---|---|---|---|---|---|---|---|---|---|---|---|---|---|---|
| "-" shows that it was below the detection limit. | | | | | | | | | | | | | | |

**[Table 3]**

| | No. | Average grain size of the W powder (µm) | Sintering pressure (GPa) | Sintering temperature (°C) | Sintering time (min) |
|---|---|---|---|---|---|
| Comparative Example | 1 | 2.0 | 0.8 | 1100 | 20 |
| | 2 | 12.1 | 5 | 1000 | 20 |
| | 3 | 18.5 | 3.7 | 800 | 120 |
| | 4 | 18.5 | 2.7 | 1600 | 5 |
| | 5 | 62.3 | 0.5 | 1100 | 10 |
| Conventional Example | 1 | 12.1 | 0.3 | 1500 | 180 |
| | 2 | 8.8 | 0.1 | 1400 | 180 |

**[Table 4]**

| | No. | Relative density (%) | Porosity (area%) | | | Average crystal grain size (µm) | | | Average aspect ratio | | | Vickers hardness HV | | |
|---|---|---|---|---|---|---|---|---|---|---|---|---|---|---|
| | | | Cross section X | Cross section Y | Cross section Z | Cross section X | Cross section Y | Cross section Z | Cross section X | Cross section Y | Cross section Z | Cross section X | Cross section Y | Cross section Z |
| Comparative Example | 1 | 89.2 | 0.68 | 0.73 | 0.89 | 3.1 | 3.6 | 3.7 | 2.1 | 1.7 | 1.1 | 441 | 460 | 455 |
| | 2 | 98.2 | 0.45 | 0.48 | 0.35 | 16.2 | 15.3 | 17.1 | 13 | 1.4 | 1.8 | 444 | 439 | 453 |
| | 3 | 94.8 | 1.41 | 1.67 | 0.83 | 33.4 | 32.6 | 30.2 | 1.9 | 1.1 | 1.5 | 431 | 442 | 438 |
| | 4 | 88.5 | 1.2 | 1.8 | 0.9 | 30.2 | 29.8 | 31.3 | 1.9 | 2.2 | 2.1 | 432 | 428 | 439 |
| | 5 | 82.9 | 1.3 | 2.1 | 1.8 | 73.2 | 68.3 | 72.6 | 1.4 | 2.2 | 1.8 | 428 | 437 | 436 |
| Conventional Example | 1 | 99.5 | 0.73 | 0.09 | 0.08 | 90 | 380 | 65 | 6.6 | 2.6 | 2.3 | 500 | 484 | 516 |
| | 2 | 99.3 | 0.08 | 0.12 | 0.15 | 58 | 245 | 195 | 3.8 | 2.1 | 4.2 | 443 | 440 | 437 |

### Example 2

As raw materials, W particle powders having the average grain size shown in Table 5, and alloy component particle powders of one or more selected from Ti, Zr, Hf, V, Nb, Ta, Cr, Mo and Mn having the average grain size shown in Table 5 were prepared. Then, mixed raw material powders were prepared by blending to obtain the compositions shown in Table 5. By pressure sintering the mixed raw material powders in the sintering condition shown in Table 5, the W alloy compacts 11 to 20 of Example of the present invention were produced.

In the production of the W alloy compacts 18 to 20 of Example of the present invention, vacuum sintering was performed in vacuum atmosphere of 10⁻¹ Pa at the reaching temperature of 580 °C to 620°C for 30 to 40 minutes after producing the green compacts from the W particle powder and the alloy component particle powder prior to sintering.

The relative density (specific gravity), the porosity, the average crystal grain size, the average aspect ratio and the Vickers hardness HV of the W alloy compacts 11 to 20 of Examples of the present invention were obtained in the same method as in Example 1

These results are shown in Table 6.

FIG. 4 shows an example of the structure of the W alloy compact 15 of Example of the present invention. FIG. 5 shows an example of a result in pore detection measured in the W alloy compact 15 of Example of the present invention shown in FIG. 4 (Software used: Image J).

For comparison, W particle powders and metal particle powders having the average grain size shown in Table 7 were prepared. Then, by sintering these powders in the sintering condition shown in Table 7 in the same manner, W alloy compacts of Comparative Examples 11 to 15 having the relative density (specific gravity), the porosity, the average crystal grain size, the average aspect ratio of the crystal grains, and the Vickers hardness HV shown in Table 8 were produced.

On the W alloy compacts of Comparative Examples 11 to 15, the relative density (specific gravity), the porosity, the average crystal grain size, the average aspect ratio, and the Vickers hardness HV shown in Table 4were obtained in the same manner as in Example 1.

These results are shown in Table 8.

In addition, as references, by using W particle powders and metal particle powders having the average grain size shown in Table 7, W alloy compacts 11 and 12 of Conventional Examples were produced by the conventional method; and the relative density (specific gravity), the porosity, the average crystal grain size, the average aspect ratio, and the Vickers hardness HV were obtained.

These results are shown in Table 8.

The W alloy compact 11 of Conventional Example was obtained by performing rolling processing. The W alloy compact 12 of Conventional Example was produced by the dissolution method.

FIG. 6 shows an example of the structure of the W alloy compact 11 of Conventional Example. FIG. 7 shows an example of a result in pore detection measured in the W alloy compact 11 of Conventional Example shown in FIG. 6 (Software used: Image J).

**[Table 5]**

| | No. | W content (mass%) | Average grain size of the W powder (µm) | Kind and content of the alloy component powder (mass%) | Average grain size of the alloy component powder (µm) | Sintering pressure (GPa) | Sintering temperature (°C) | Sintering time (min) |
|---|---|---|---|---|---|---|---|---|
| Example of the present invention | 11 | 80 | 6.0 | 15Ti-5Hf | 2 | 7.7 | 1800 | 20 |
| | 12 | 25 | 6.0 | 50Mo-25Cr | 4 | 2.5 | 1600 | 30 |
| | 13 | 50 | 6.0 | 25Mo-25Mn | 8 | 2.7 | 1400 | 120 |
| | 14 | 75 | 6.0 | 25Mo | 2 | 6.1 | 1400 | 20 |
| | 15 | 50 | 6.0 | 50Mo | 2 | 5 | 1700 | 10 |
| | 16 | 25 | 6.0 | 75Mo | 2 | 3.7 | 1500 | 30 |
| | 17 | 50 | 6.0 | 50Nb | 10 | 4.5 | 1400 | 120 |
| | 18 | 75 | 6.0 | 20Nb-5V | 8 | 2.7 | 1200 | 180 |
| | 19 | 75 | 6.0 | 15Mo-10Zr | 4 | 4.5 | 1500 | 20 |
| | 20 | 90 | 6.0 | 5Zr-5Ta | 8 | 7.7 | 1800 | 30 |

**[Table 6]**

| | No. | Relative density (%) | Porosity (area%) | | | Average crystal grain size (µm) | | | Average aspect ratio | | | Vickers hardness HV | | |
|---|---|---|---|---|---|---|---|---|---|---|---|---|---|---|
| | | | Cross section X | Cross section Y | Cross section Z | Cross section X | Cross section Y | Cross section Z | Cross section X | Cross section Y | Cross section Z | Cross section X | Cross section Y | Cross section Z |
| Example of the present invention | 11 | 99.6 | 0.08 | - | 0.05 | 7.4 | 6.8 | 7.6 | 1.1 | 1.9 | 2.2 | 425 | 412 | 433 |
| | 12 | 99.4 | 0.12 | - | 0.16 | 8.2 | 7.9 | 10.2 | 1.7 | 1.3 | 1.7 | 335 | 329 | 328 |
| | 13 | 99.5 | 0.14 | 0.07 | 0.19 | 12.4 | 14.2 | 10.5 | 1.4 | 2.2 | 1.8 | 345 | 339 | 336 |
| | 14 | 99.7 | 0.07 | - | - | 6.9 | 8.3 | 8.7 | 1.8 | 2.1 | 2.1 | 382 | 368 | 375 |
| | 15 | 99.4 | - | - | 0.12 | 10.7 | 12.1 | 14 | 1.2 | 1.4 | 1.2 | 349 | 325 | 336 |
| | 16 | 99.5 | 0.09 | 0.19 | - | 8.6 | 6.7 | 9.6 | 1.6 | 2.2 | 1.6 | 327 | 335 | 324 |
| | 17 | 99.4 | - | 0.14 | 0.06 | 14.6 | 16.4 | 12.8 | 1.9 | 2.1 | 1.3 | 350 | 342 | 347 |
| | 18 | 99.4 | - | 0.13 | - | 13.6 | 11.6 | 10.8 | 1.1 | 1.8 | 1.8 | 362 | 356 | 365 |
| | 19 | 99.4 | 0.04 | - | 0.08 | 8.7 | 9.7 | 10.7 | 1.4 | 1.7 | 2.2 | 374 | 384 | 386 |
| | 20 | 99.8 | - | - | - | 18.3 | 16.2 | 16.7 | 1.6 | 1.1 | 2.3 | 448 | 443 | 439 |

| | | | | | | | | | | | | | | |
|---|---|---|---|---|---|---|---|---|---|---|---|---|---|---|
| "-" shows that it was below the detection limit. | | | | | | | | | | | | | | |

**[Table 7]**

| | No. | W content (mass%) | Average grain size of the W powder (µm) | Kind and content of the alloy component powder (mass%) | Average grain size of the alloy component powder (µm) | Sintering pressure (GPa) | Sintering temperature (°C) | Sintering time (min) |
|---|---|---|---|---|---|---|---|---|
| Comparative Example | 11 | 10 | 6.0 | 75Nb-15V | 8.8 | 1 | 1200 | 120 |
| | 12 | 50 | 6.0 | 25Mo-25Cr | 6.2 | 2.7 | 600 | 180 |
| | 13 | 25 | 6.0 | 50Mo-25Mn | 86.4 | 2.5 | 1400 | 5 |
| | 14 | 75 | 80.3 | 10Ti-15Hf | 123.2 | 3.7 | 1400 | 30 |
| | 15 | 75 | 103.8 | 15Mo-10Zr | 2.3 | 5.5 | 1200 | 20 |
| Conventional Example | 11 | 75 | 6.0 | 25Mo | 2.1 | 0.3 | 1500 | 180 |
| | 12 | 75 | 6.0 | 25Mo-5Cr | 2.1 | 0.1 | 1400 | 180 |

**[Table 8]**

| | No. | Relative density (%) | Porosity (area%) | | | Average crystal grain size (µm) | | | Average aspect ratio | | | Vickers hardness HV | | |
|---|---|---|---|---|---|---|---|---|---|---|---|---|---|---|
| | | | Cross section X | Cross section Y | Cross section Z | Cross section X | Cross section Y | Cross section Z | Cross section X | Cross section Y | Cross section Z | Cross section X | Cross section Y | Cross section Z |
| Comparative Example | 11 | 86.3 | 1.6 | 1.8 | 2.1 | 12.3 | 14.5 | 11.8 | 1.5 | 1.8 | 1.1 | 318 | 326 | 337 |
| | 12 | 89.6 | 1.3 | 1.4 | 1.1 | 6.5 | 7.4 | 8.1 | 1.8 | 2.1 | 1.6 | 229 | 238 | 242 |
| | 13 | 93.4 | 0.89 | 0.76 | 0.85 | 97 | 117 | 124 | 1.6 | 1.4 | 1.8 | 364 | 388 | 376 |
| | 14 | 95.2 | 0.34 | 0.52 | 0.36 | 110 | 106 | 117 | 1.9 | 1.1 | 2.1 | 420 | 436 | 418 |
| | 15 | 97.8 | 0.18 | 0.25 | 0.32 | 106 | 121 | 116 | 1.9 | 2.3 | 1.6 | 369 | 347 | 365 |
| Conventional Example | 11 | 99.1 | 0.69 | 0.52 | 0.81 | 10.2 | 8.2 | 64.7 | 2.8 | 5.7 | 1.9 | 376 | 356 | 349 |
| | 12 | 99.4 | 1.13 | 1.26 | 0.97 | 32.6 | 6.5 | 5.4 | 2.3 | 4.5 | 3.9 | 255 | 267 | 278 |

According to the results shown in Tables 2, 4, 6 and 8, any one of the W compacts and the W alloy compacts of Examples of the present invention had high relative densities of 99% or more. Moreover, they were sintered compacts, in which the porosities observed in arbitrary cross sections of the sintered compacts were 0.2 area% or less; the average crystal grain sizes were 50 µm or less; and the average aspect ratios of the crystal grains were 1 to 2.5, made of fine grain structure free of anisotropy.

Contrary to that, in the W compacts of Comparative Examples; the W compacts of Conventional Examples; the W alloy compacts of Comparative Examples; and the W alloy compacts of Conventional Examples, at least any one of the relative density, the porosity, the average crystal grain size, and the average aspect ratio of the crystal grains was deviated from the ranges defined in the scope of the present invention, clearly demonstrating that they were not regarded as the sintered compact having high density and was free of anisotropy.

### INDUSTRIAL APPLICABILITY

The W compact and the W alloy compact of the present invention can be suitably used for applications such as the material of the sputtering target and the electrode material for fusing welding, for example, since they have high density and are free of anisotropy.

## Claims

1. A polycrystalline tungsten compact, having high density, made of a fine grain structure, and free of anisotropy, wherein
a relative density of the compact is 99% or more,
a porosity of the compact measured in an arbitrary cross section of the compact is 0.2 area% or less,
an average crystal grain size is 50 µm or less, and
an average aspect ratio of crystal grains is 1 to 2.5.

2. The polycrystalline tungsten compact according to Claim 1, wherein the porosity is 0.02 area% to 0.19 area %.

3. The polycrystalline tungsten compact according to Claim 1, wherein the porosity is 0.02 area% to 0.15 area %.

4. The polycrystalline tungsten compact according to Claim 1, wherein the average crystal grain size is 0.8 µm to 33.4 µm.

5. The polycrystalline tungsten compact according to Claim 1, wherein the average crystal grain size is 0.8 µm to 18.3 µm.

6. The polycrystalline tungsten compact according to Claim 1, wherein the average aspect ratio is 1.0 to 2.2.

7. The polycrystalline tungsten compact according to Claim 1, wherein the average aspect ratio is 1.0 to 1.4.

8. A polycrystalline tungsten-based alloy compact, having high density, made of a fine grain structure, and free of anisotropy, wherein
the polycrystalline tungsten-based alloy includes: tungsten at 25 mass% or more; and one or more of alloy components selected from Ti, Zr, Hf, V, Nb, Ta, Cr, Mo and Mn,
a relative density of the compact is 99% or more,
a porosity of the compact measured in an arbitrary cross section of the compact is 0.2 area% or less,
an average crystal grain size is 50 µm or less, and
an average aspect ratio of crystal grains is 1 to 2.5.

9. The polycrystalline tungsten-based alloy compact according to Claim 8, wherein the porosity is 0.02 area% to 0.19 area %.

10. The polycrystalline tungsten-based alloy compact according to Claim 8, wherein the porosity is 0.02 area% to 0.15 area %.

11. The polycrystalline tungsten-based alloy compact according to Claim 8, wherein the average crystal grain size is 0.8 µm to 33.4 µm.

12. The polycrystalline tungsten-based alloy compact according to Claim 8, wherein the average crystal grain size is 0.8 µm to 18.3 µm.

13. The polycrystalline tungsten-based alloy compact according to Claim 8, wherein the average aspect ratio is 1.0 to 2.2.

14. The polycrystalline tungsten-based alloy compact according to Claim 8, wherein the average aspect ratio is 1.0 to 1.4.

15. A method of producing a polycrystalline tungsten compact or a polycrystalline tungsten-based alloy compact having high density, made of a fine grain structure, and free of anisotropy, the method comprising the steps of:
preparing a raw material powder made of tungsten particles having an average grain size of 50 µm or less, or a raw material powder in which a tungsten particle powder having an average grain size of 50 µm or less and an alloy component particle powder of one or more selected from Ti, Zr, Hf, V, Nb, Ta, Cr, Mo and Mn having an average grain size of 50 µm or less are blended;
inserting either of the raw material powders or a green compact of either of the raw material powders in a pressure sintering apparatus; and
sintering the either of the raw material powders or the green compact in a state where a pressing of 2.55 GPa or more and 13 GPa or less is loaded on the either of the raw material powders or the green compact in a temperature range of 1200°C or more and a melting point or less.
